# FASCICULE DE BREVET EUROPEEN

(11) **EP 1 916 315 B1**
(45) Date de publication et mention de la délivrance du brevet: **08.08.2012**
(21) Numéro de dépôt: 07116556.7
(22) Date de dépôt: 17.09.2007
(51) Int. Cl.: C23C 16/04, C23C 16/511, B05D 7/22

(54) **Installation de dépôt au moyen d'un plasma micro-onde d'un revêtement formant barrière interne dans des récipients thermoplastiques**
Beschichtungsvorrichtung von einer inneren Barriereschicht in thermoplastischen Behältern durch Mikrowellen-Plasma
Internal barrier coating apparatus using microwave plasma for thermoplastic container

(30) Priorité: 11.10.2006 FR 0608915
(43) Date de publication de la demande: 30.04.2008
(73) Titulaire: Sidel Participations, 76930 Octeville Sur Mer (FR)
(72) Inventeur: Duclos, Yves Alban, 76930, Octeville Sur Mer (FR); Cirette, Damien, 76930, Octeville Sur Mer (FR)
(74) Mandataire: Cabinet Plasseraud

(56) Documents cités:
- EP-A- 0 778 089
- WO-A-99/17334
- WO-A-03/100115
- FR-A1- 2 847 912
- FR-A1- 2 871 813
- FR-A1- 2 872 148
- FR-A1- 2 872 555

## Description

La présente invention concerne d'une façon générale le domaine de la fabrication de récipients thermoplastiques, notamment en PET, dont la paroi est pourvue d'une couche interne d'un revêtement barrière, par exemple en carbone, silice ou autre, propre à empêcher ou freiner les échanges moléculaires ou ioniques à travers la paroi.

L'invention concerne plus spécifiquement des perfectionnements apportés aux installations de dépôt, au moyen d'un plasma micro-ondes, d'un revêtement formant barrière sur la face interne de récipients en matière thermoplastique tel que du PET, cette installation comprenant une multiplicité de postes de traitement de récipients qui comportent chacun une enceinte de traitement et un bloc supérieur formant couvercle incluant une chambre de pompage à vide dans laquelle des moyens de raccordement étanche avec le récipient comportent une chemise de forme générale tubulaire coaxiale au col du récipient, chaque couvercle supportant également un injecteur coaxial à ladite chemise propre à injecter un fluide réactionnel à l'intérieur du récipient lors du traitement.

Une installation du type considéré est décrite et illustrée dans le document FR 2 872 148.

Pendant le traitement du récipient, un champ de micro-ondes est émis à l'intérieur de l'enceinte de traitement et ce champ se développe vers la chambre de pompage à travers la chemise. Les micro-ondes qui se propagent à l'intérieur de la chemise et à l'intérieur de la chambre de pompage y provoquent des dépôts de particules de matériau barrière (carbone, silice ou autre), ce qui pollue les parois internes de la chemise et de la chambre de pompage, voire même les parois internes du circuit de pompage. Des dépôts se forment de la même manière sur la paroi externe de l'injecteur qui plonge dans le récipient.

Pour cette raison, il est nécessaire de procéder fréquemment à un nettoyage de la chemise et de l'injecteur, ainsi que de la chambre de pompage. Pour ce faire, la chemise et l'injecteur doivent être démontés individuellement. Le document FR 2 872 148 montre un agencement qui permet le montage et le démontage de la chemise sur l'enceinte.

Ces opérations sont longues, doivent être répétées autant de fois que l'installation compte de postes de traitement, et nécessitent une immobilisation de l'installation qui est coûteuse.

Par ailleurs, les exploitants de ces installations demandent des cadences de production toujours accrues. Un accroissement des cadences de fabrication peut certes être obtenu par des améliorations apportées ponctuellement dans la conception des diverses parties ou éléments constituants de l'installation. Cependant, pour l'obtention d'un résultat satisfaisant, la durée du déroulement du processus de dépôt de la couche de matériau barrière ne peut pas être raccourcie de façon suffisante pour qu'il en résulte une augmentation significative de la cadence de production de l'installation, laquelle semble, dans l'état actuel de la technique, ne pouvoir être obtenue qu'à travers une augmentation sensible du nombre des postes de traitement de l'installation. Il en résulte que le problème des contraintes engendrées par le nettoyage des chemises, des injecteurs et de la chambre de pompage se pose alors de façon encore plus cruciale.

Les documents FR 2 847 912 et FR 2 871 813 montrent (respectivement figure 2 et figure 3) un agencement de poste de dépôt, au moyen d'un plasma micro-ondes, d'un revêtement barrière à l'intérieur d'un récipient thermoplastique. Cet agencement correspond à une structure plus ancienne et différente de celle du document précédent FR 2 872 148 : le poste de traitement comprend une enceinte munie d'un fond fixe et équipée d'un couvercle mobile, le soulèvement du couvercle (avec les injecteurs) étant requis pour le chargement et le déchargement des récipients par le haut. Cet agencement connu est tel qu'un même et unique poste de traitement permet de traiter simultanément deux récipients : à cet effet, il est prévu notamment deux injecteurs solidaires l'un de l'autre et réunis à un tube commun de raccordement à une source, l'ensemble étant supporté de façon fixe par l'unique couvercle du poste de traitement. Ce type d'agencement n'est pas concerné par les inconvénients évoqués plus haut qui affectent spécifiquement les dispositifs postérieurs objets du document FR 2 872 148.

L'invention a essentiellement pour but de proposer une solution technique perfectionnée au problème qui se pose en relation avec le dispositif du document FR 2 872 148 précité, de manière à répondre de façon aussi satisfaisante que possible aux attentes des exploitants des installations concernées.

A ces fins, l'invention propose une installation telle que définie à la revendication 1.

Grâce à cet agencement, la platine et les organes desdits postes du groupe de postes qu'elle supporte constituent un ensemble unitaire manoeuvrable en bloc, ce qui permet une manipulation plus rapide pour mettre en place lesdits organes sur les couvercles respectifs ou les en enlever. Le temps d'immobilisation de l'installation aux fins de remplacement des organes concernés peut ainsi être considérablement réduit, même lorsque l'installation comporte un nombre sensiblement accru de postes de traitement.

Dans un mode de réalisation possible de l'invention, lesdits organes sont des chemises et les chemises desdits postes adjacents du groupe de postes sont solidaires d'une platine porte-chemises unique qui s'étend en pont au-dessus des couvercles desdits postes.

Dans un autre mode de réalisation possible, les organes sont des injecteurs et les injecteurs de plusieurs postes adjacents du groupe de postes sont solidaires d'une platine porte-injecteurs unique qui s'étend en pont au-dessus des couvercles desdits postes.

Tel que défini dans l'invention les chemises de plusieurs postes adjacents du groupe de postes sont solidaires d'une platine porte-chemises unique qui s'étend en pont au-dessus des couvercles desdits postes, les injecteurs de plusieurs postes adjacents du groupe de postes sont solidaires d'une platine porte-injecteurs unique qui s'étend en pont au-dessus des couvercles desdits postes, et la platine porte-injecteurs est située au-dessus de la platine porte-chemises. Ainsi c'est l'ensemble des chemises et des injecteurs d'un groupe de postes qui peut être manipulé par blocs.

Dans un mode de réalisation préféré, on prévoit que chaque platine comporte, dans sa partie centrale, un moyen de préhension propre à la manoeuvre de l'ensemble unitaire concerné. Notamment on peut avantageusement prévoir que la platine porte-chemises et la platine porte-injecteurs, dans leurs parties centrales respectives, sont mutuellement décalées dans des sens transversalement opposés et que les moyens de préhension respectifs sont situés côte à côte. Cette disposition permet d'envisager une manipulation des ensembles de façon automatique mais éventuellement individuelle, à l'aide d'un robot, de manière à accroître la rapidité de l'intervention.

En ayant constamment à l'esprit la rapidité de manoeuvre et l'automatisation des montages/démontages, il est intéressant que chaque ensemble unitaire formé par une platine et les chemises ou les injecteurs qu'elle supporte soit agencé pour établir automatiquement des liaisons fluidiques et/ou électriques avec les couvercles associés.

Pour éviter un endommagement du matériel au cours des montages et démontages, il est souhaitable que chaque platine soit munie d'au moins un doigt de guidage qui est sensiblement parallèle aux axes des organes supportés par ladite platine et qui est reçu dans l'élément (respectivement le couvercle ou la platine porte-chemises) sous-jacent à ladite platine (respectivement platine porte-chemises ou platine porte-injecteurs). En particulier, dans le cas où l'on a recours conjointement à une platine porte-chemises et à une platine porte-injecteurs, on prévoit alors que la platine porte-chemises soit munie d'au moins un passage traversant propre à être traversé par le au moins un doigt de guidage de la platine porte-injecteurs située supérieurement.

Dans un mode de réalisation concret, les postes de traitement sont répartis en groupes comprenant plusieurs postes adjacents et chaque platine supporte plusieurs organes appartenant aux postes adjacents respectifs d'un groupe de postes. En pratique, l'installation comporte un nombre pair de postes, chaque groupe de postes comprend deux postes adjacents et chaque platine supporte deux organes appartenant à deux postes adjacents d'un groupe de postes. Dans ce cas, il est souhaitable, par souci de simplification structurelle, que les enceintes des deux postes adjacents d'un groupe de postes soient rapprochées l'une contre l'autre et juxtaposées.

Les dispositions conformes à l'invention sont plus faciles à mettre en oeuvre dans une installation dans laquelle, pour chaque poste,
le bloc supérieur formant couvercle est fixe et solidaire de l'enceinte respective, et
le fond de l'enceinte est déplaçable axialement pour autoriser l'introduction et l'évacuation des récipients, disposés col en haut, par le bas de l'enceinte.

Les dispositions conformes à l'invention semblent devoir trouver une application tout particulièrement intéressante dans les installations du type carrousel tournant comportant un bâti rotatif supportant ladite multiplicité de postes répartis périmétriquement.

L'invention sera mieux comprise à la lecture de la description détaillée qui suit de certains modes de réalisation préférés donnés uniquement à titre d'exemples nullement limitatifs. Dans cette description, on se réfère aux dessins annexés sur lesquels :
- la figure 1 est une vue en coupe, de face, d'une partie d'un mode de réalisation préféré d'une installation agencée conformément à l'invention pour déposer, au moyen d'un plasma micro-ondes, un revêtement formant barrière sur la face interne de récipients en matière thermoplastique ;
- la figure 2 est une vue extérieure éclatée de la partie de l'installation représentée à la figure 1 ; et
- les figures 3 et 4 sont des vues en coupe de deux composants de l'installation des figures 1 et 2 agencés conformément à l'invention.

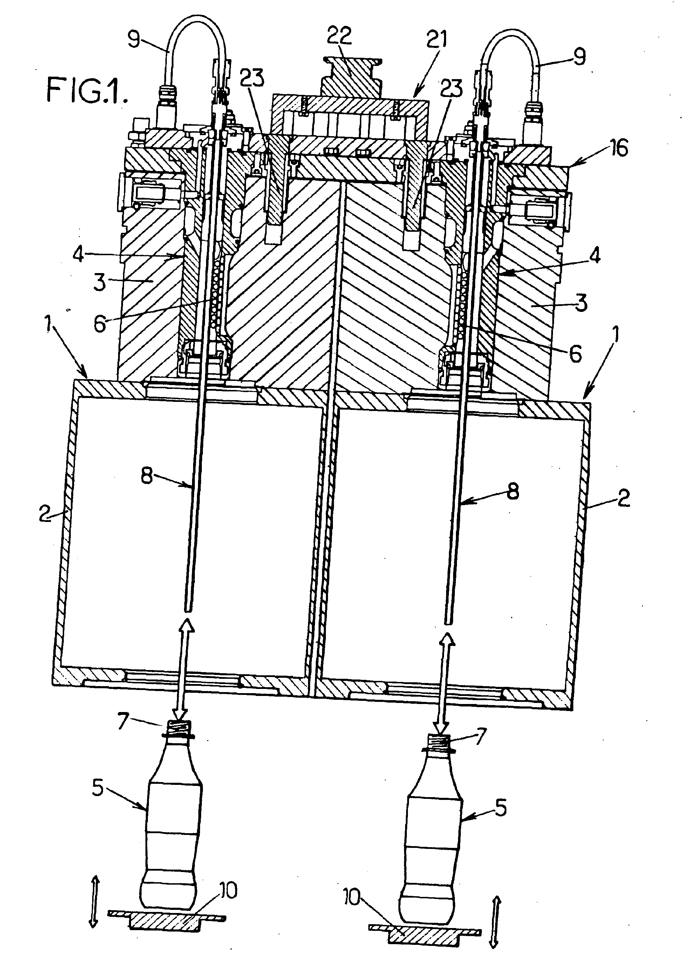

On se reporte maintenant aux figures 1 à 3 sur lesquelles est représentée une partie d'une installation pour déposer, au moyen d'un plasma micro-ondes, un revêtement formant barrière sur la face interne de récipients en matière thermoplastique tel que du PET, cette installation comprenant une multiplicité de postes de traitement, en général individuel, de récipients. En pratique, dans une installation industrielle destinée à traiter des récipients avec une cadence élevée, une telle installation se présente sous l'aspect d'un carrousel tournant supportant la multiplicité de postes de traitement répartis sur son pourtour. Pour fixer les idées, une installation de ce type actuellement commercialisée par la Demanderesse est équipée de 20 postes de traitement, et la Demanderesse envisage la commercialisation d'une installation de capacité fortement accrue et typiquement portée à environ 40 postes de traitement, pour laquelle les dispositions conformes à l'invention sont plus particulièrement destinées à être mises en oeuvre bien qu'il ne s'agisse pas là d'une application exclusive.

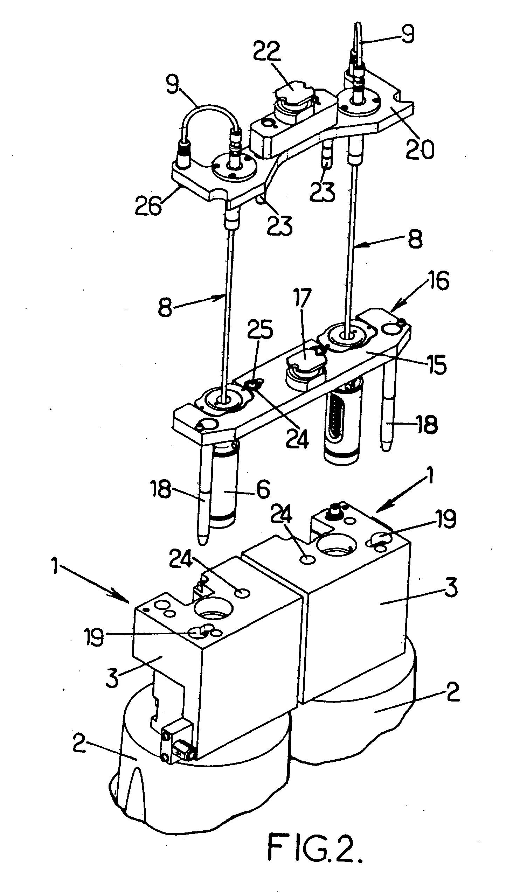

Aux figures 1 et 2, par souci de simplification et de clarté, seules sont montrées les parties de l'installation qui sont utiles à la compréhension de l'invention ; ainsi, seul est représenté un groupe de postes de traitement adjacents de l'installation concernés ensembles par les dispositions de l'invention, étant entendu que tous les autres groupes de postes de traitement sont agencés identiquement. Dans l'exemple illustré, on suppose que l'installation comporte un nombre pair de postes de traitement et que chaque groupe de postes est constitué de deux postes adjacents car c'est actuellement cette configuration qui s'avère simple à mettre en oeuvre sur le plan structurel et fonctionnel tout en conduisant aux simplifications fonctionnelles recherchées, étant cependant entendu que les dispositions de l'invention peuvent parfaitement être transposées à des groupes de postes comprenant un nombre de postes de traitement supérieur à deux.

Pour l'essentiel, chaque poste 1 de traitement comporte une enceinte 2 de traitement et un couvercle 3 qui inclut une chambre de pompage à vide (non visible sur les dessins) dans laquelle des moyens 4 de raccordement étanche avec le récipient 5 comportent une chemise 6 de forme générale tubulaire coaxiale au col 7 du récipient. Chaque couvercle 3 supporte également un injecteur 8 coaxial à ladite chemise 6 et propre à injecter un fluide réactionnel dans le récipient 5 lors du déroulement du processus de traitement dudit récipient pour la formation d'une couche de matériau barrière sur la face intérieure de celui-ci.

Les postes 1 de traitement sont supportés par un bâti commun, lequel, dans le contexte d'une machine à nombre élevé de postes de traitement est un bâti rotatif du type carrousel sur lequel les postes de traitement sont répartis circulairement.

Le document FR 2 872 148 décrit et illustre de façon détaillée un agencement d'un tel poste de traitement.

On soulignera cependant que, dans le document précité, le poste de travail qui y est décrit et représenté est agencé de la façon qui est traditionnelle dans les machines étudiées et produites jusqu'à présent par la Demanderesse, avec un couvercle déplaçable vis-à-vis de l'enceinte, au-dessus de celle-ci, pour permettre l'introduction des récipients dans l'enceinte préalablement à leur traitement et leur extraction hors de l'enceinte une fois le traitement achevé, cette introduction et cette extraction s'effectuant par le haut de l'enceinte. Cette architecture cependant nécessite, pour dégager la place nécessaire au passage des récipients, des déplacements de grande amplitude, dans la partie haute de la machine, du couvercle et de tous les matériels qu'il supporte (chemise, injecteur et leurs organes de support notamment), et en particulier des tubulures flexibles de raccordement aux diverses sources de fluides (vide, gaz réactionnel, ...). Les déformations répétées de ces tubulures flexibles nécessitent une surveillance et un entretien permanents pour éviter les incidents en cours de fonctionnement de la machine. De plus, pour faciliter l'accès aux organes nécessitant un entretien ou un remplacement régulier, la structure du couvercle et des organes de support s'avère complexe, avec des parties pivotantes, des moyens de verrouillage, des organes d'étanchéité).

C'est pour remédier à ces inconvénients que les postes de travail représentés aux figures 1 et 2 des dessins annexés sont agencés différemment avec le couvercle 3 conçu sous forme d'un bloc supérieur fixe solidaire de l'enceinte 2, de telle sorte que les organes supportés par ledit bloc ne sont animés d'aucun déplacement, que les tubulures peuvent être remplacées en grand nombre par des canaux usinés dans le bloc et que les tubulures subsistantes (tubulure 9 de raccordement de l'injecteur 8 au bloc par exemple) ne sont prévues que pour faciliter le démontage et le montage de l'injecteur dans des conditions qui seront exposées plus loin et ne subissent plus de déformations répétées au cours du fonctionnement de la machine.

Ceci conduit à introduire ou extraire les récipients par le dessous de l'enceinte, avec mise en oeuvre d'un fond 10 qui est déplaçable verticalement (à la figure 1, les postes 1 de travail sont montrés en position de chargement/déchargement des récipients 5, les fonds 10 étant abaissés). Les autres parties de l'installation sont sans relation directe, structurellement et fonctionnellement, avec les dispositions de l'invention et ne seront pas décrites, bien que certaines soient visibles sur les figures 1 et 2.

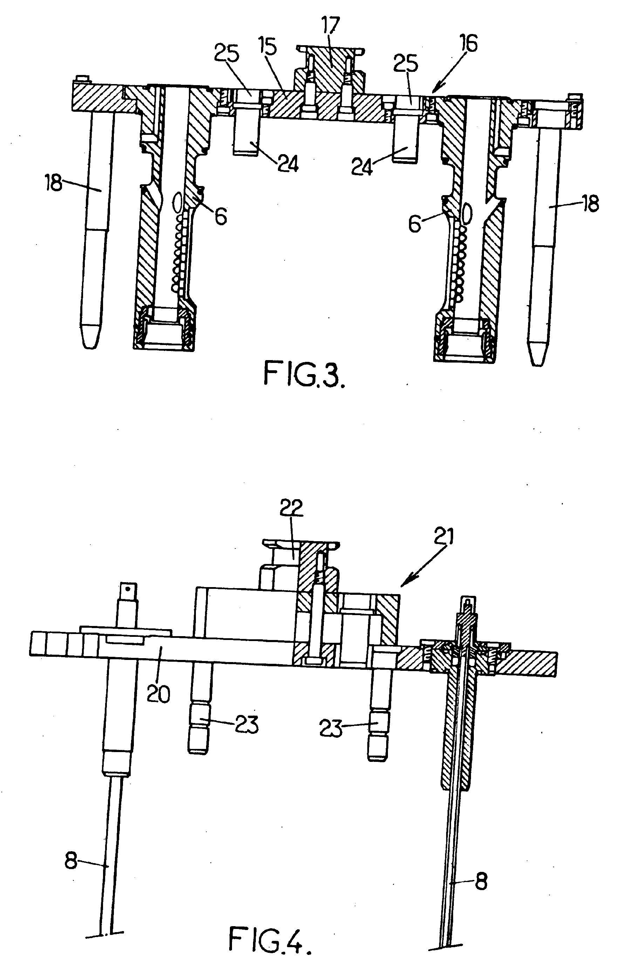

Les dispositions conformes à l'invention vont maintenant être exposées en se référant non seulement aux figures 1 et 2, mais aussi aux figures 3 et 4 à échelle agrandie.

Les chemises 6 des deux postes 1 adjacents constituant un groupe de postes de traitement sont solidaires d'une platine 15 porte-chemises unique qui s'étend en pont au-dessus des couvercles 3 desdits postes. Ainsi, la platine 15 porte-chemises et les deux chemises 6 qui en sont solidaires constituent un ensemble 16 unitaire qui est manoeuvrable en bloc pour mettre en place lesdites chemises 6 sur les couvercles respectifs ou les en enlever. Le temps exigé par la manipulation d'un tel ensemble 16 est réduit quasiment de moitié par rapport à celui nécessité par les manipulations successives individuelles de deux chemises 6 prises isolément.

Avantageusement, la platine 15 porte-chemises comporte, dans sa partie centrale, un moyen de préhension, tel qu'un pion 17 saillant, propre à la manoeuvre de l'ensemble 16 unitaire notamment à l'aide d'un bras de préhension.

Avantageusement également, des moyens de guidage et éventuellement de détrompage sont associés à la platine 15 porte-chemises et aux couvercles 3. Dans l'exemple de réalisation illustré, la platine 15 porte-chemises est munie d'au moins un doigt 18 de guidage sensiblement parallèle aux axes des chemises 6 et le couvercle 3 correspondant est pourvu d'au moins un logement 19 de guidage respectif propre à recevoir ledit doigt 18 de guidage ; en l'occurrence, il est prévu deux doigts 18 distants l'un de l'autre sur la platine 15, ainsi que deux logements 19 de guidage respectifs dans les couvercles 3.

On peut prévoir un agencement analogue pour les injecteurs 8. Les injecteurs 8 des deux postes 1 adjacents constituant un groupe de postes de traitement sont solidaires d'une platine 20 porte-injecteurs unique qui s'étend en pont au-dessus des couvercles 3 desdits postes. Ainsi, la platine 20 porte-injecteurs et les deux injecteurs 8 qui en sont solidaires constituent un ensemble 21 unitaire qui est manoeuvrable en bloc pour mettre en place lesdits injecteurs 8 sur les couvercles 3 respectifs ou les en enlever. De même que pour les chemises 6, le temps exigé par la manipulation d'un tel ensemble 21 est réduit quasiment de moitié par rapport à celui nécessité par les manipulations successives individuelles de deux injecteurs 8 pris isolément.

Avantageusement, la platine 20 porte-injecteurs comporte, dans sa partie centrale, un moyen de préhension, tel qu'un pion 22 saillant, propre à la manoeuvre de l'ensemble 21 unitaire notamment à l'aide d'un bras de préhension.

Avantageusement également, des moyens de guidage et éventuellement de détrompage calqués sur ceux évoqués plus haut pour la platine porte-chemises peuvent être associés à la platine 20 porte-injecteurs.

De façon pratique, les chemises 6 et les injecteurs 8 sont présents simultanément dans les postes 1. On est donc conduit à superposer les deux ensembles 16, 21 unitaires : l'ensemble 16 avec les chemises 6 est disposé en situation inférieure au contact des couvercles 3, tandis que l'ensemble 21 avec les injecteurs 8 est disposé par-dessus celui-ci, les injecteurs 8 étant engagés coaxialement dans les chemises 6.

Avantageusement alors, les moyens de guidage et éventuellement de détrompage associés à la platine 20 porte-injecteurs peuvent être agencés comme montré dans l'exemple de réalisation illustré : la platine 20 porte-injecteurs est munie d'au moins un doigt 23 de guidage sensiblement parallèle aux axes des injecteurs 8 et la platine 15 porte-chemises correspondante sous-jacente est pourvue d'au moins un logement 25 de guidage respectif (par exemple défini dans une bague 24 de guidage rapportée sur la platine porte-chemises comme illustré) propre à recevoir ledit doigt 23 de guidage ; en l'occurrence, il est prévu deux doigts 23 distants l'un de l'autre sur la platine 20, ainsi que deux bagues 24 de guidage respectives dans les platines 15 porte-chemises. Dans le couvercle 3 sont aménagés deux orifices 24 destinés à laisser passer les bagues 24 de guidage de la platine 15 porte-chemises.

En outre, dans leurs parties centrales respectives, la platine 15 porte-chemises et la platine 20 porte-injecteurs sont mutuellement décalées dans des sens transversalement opposés comme visible à la figure 2 et les moyens 17, 22 de préhension respectifs sont situés côte à côte.

Avantageusement, lorsque la platine 20 porte-injecteurs est posée sur la platine 15 porte-chemises, le moyen 17 de préhension de la platine 15 porte-chemises permet de manutentionner en bloc l'ensemble des deux platines porte-injecteurs et porte-chemises.

Enfin, comme visible à la figure 1, chaque ensemble 16, 21 unitaire est agencé pour établir automatiquement des liaisons fluidiques et/ou électriques nécessaires avec les couvercles 3 associés, telles que les connexions 26 (visibles à la figure 2) destinées à l'alimentation des injecteurs 8 (via des tubulures 9 flexibles dans le but de faciliter le démontage des injecteurs).

Pour simplifier au mieux la structure et réduire la dimension des platines 15 porte-chemises et 20 porte-injecteurs, les enceintes 3 des deux postes 1 adjacents d'un groupe de postes peuvent avantageusement être rapprochées l'une contre l'autre au plus près l'une de l'autre et juxtaposées, comme cela est clairement représenté sur les figures 1 et 2.

Grâce aux dispositions conformes à l'invention qui viennent d'être exposées, on rend plus faciles et surtout plus rapides les étapes de remplacement des chemises 6 et des injecteurs 8. Au surplus, compte tenu de la configuration donnée aux ensembles 16, 21 unitaires, ces opérations de montage et démontage des ensembles unitaires peuvent être automatisées de sorte qu'il est possible d'envisager un processus d'entretien des chemises 6 et des injecteurs 8 qui soit entièrement automatisé.

Dans la description détaillée qui précède, on a considéré plus particulièrement la réalisation exploitée en pratique consistant à prévoir un nombre pair de postes 1 de traitement, à réunir les postes de traitement par groupes de deux postes adjacents et à faire en sorte que chaque platine 15, 20 supporte deux organes (chemise 6 ; injecteur 8) appartenant aux deux postes de traitement adjacents respectifs d'un groupe de postes. Toutefois, on comprendra que les dispositions de l'invention peuvent trouver application lorsque les postes de traitement sont répartis en groupes comprenant un nombre quelconque de postes de traitement adjacents, chaque platine supportant alors plusieurs organes appartenant aux postes adjacents respectifs d'un groupe de postes.

## Revendications

1. Installation de dépôt, au moyen d'un plasma micro-ondes, d'un revêtement formant barrière sur la face interne de récipients (5) en matière thermoplastique tel que du PET, cette installation comprenant une multiplicité de postes (1) de traitement de récipients qui comportent chacun une enceinte (2) de traitement et un bloc supérieur formant couvercle (3) incluant une chambre de pompage à vide dans laquelle des moyens (4) de raccordement étanche avec le récipient (5) comportent une chemise (6) de forme générale tubulaire coaxiale au col (7) du récipient (5), chaque couvercle (3) supportant également un injecteur (8) coaxial à ladite chemise (6) propre à injecter un fluide réactionnel dans le récipient (5) lors du traitement, **caractérisée en ce que** des organes sont choisis parmi les chemises (6) et les injecteurs (8), de plusieurs postes (1) adjacents formant un groupe de postes,
- **en ce que** les chemises (6) desdits postes (1) adjacents du groupe de postes sont solidaires d'une platine (15) porte-chemises unique qui s'étend en pont au-dessus des couvercles (3) desdits postes,
- **en ce que** les injecteurs (8) desdits postes (1) adjacents du groupe de postes sont solidaires d'une platine (20) porte-injecteurs unique qui s'étend en pont au-dessus des couvercles (3) desdits postes, et
- **en ce que** la platine (20) porte-injecteurs est située au-dessus de la platine (15) porte-chemises,
ce grâce à quoi ladite platine (15, 20) et les organes (6, ce grâce à quoi ladite platine (15, 20) et les organes (6, 8) desdits postes (1) du groupe de postes qu'elle supporte constituent un ensemble (16, 21) unitaire manoeuvrable en bloc pour mettre en place lesdits organes (6, 8) sur les couvercles (3) respectifs ou les en enlever.

2. Installation selon la revendication 1, **caractérisée en ce que** chaque platine (15, 20) comporte, dans sa partie centrale, un moyen (17, 22) de préhension propre à la manoeuvre de l'ensemble (16, 21) unitaire.

3. Installation selon les revendications 1 et 2, **caractérisée en ce que**, dans leurs parties centrales respectives, la platine (15) porte-chemises et la platine (20) porte-injecteurs sont mutuellement décalées dans des sens transversalement opposés, **en ce que** les moyens (17, 22) de préhension respectifs sont situés côte à côte, et **en ce que** le moyen (17) de préhension de la platine (15) porte-chemises, située en dessous, permet de manutentionner en bloc l'ensemble des deux platines porte-chemises (15) et porte-injecteurs (20).

4. Installation selon l'une quelconque des revendications 1 à 3, **caractérisée en ce que** chaque ensemble (16, 21) unitaire est agencé pour établir automatiquement des liaisons (26) fluidiques et/ou électriques avec les couvercles (3) associés.

5. Installation selon l'une quelconque des revendications 1 à 4, **caractérisée en ce que** chaque platine (15, 20) est munie d'au moins un doigt (18, 23) de guidage qui est sensiblement parallèle aux axes des organes (6, 8) supportés par ladite platine et qui est reçu dans l'élément sous-jacent à ladite platine.

6. Installation selon les revendications 1 et 5, **caractérisée en ce que** la platine (15) porte-chemises située inférieurement est munie d'au moins un logement (25) traversant propre à être traversé par le au moins un doigt (23) de guidage de la platine (20) porte-injecteurs située supérieurement.

7. Installation selon la revendication 6, **caractérisée en ce qu'**elle comporte un nombre pair de postes (1), **en ce que** chaque groupe de postes comprend deux postes (1) adjacents et **en ce que** chaque platine (15, 20) supporte plusieurs organes (6, 8) appartenant aux deux postes (1) adjacents respectifs d'un groupe de postes.

8. Installation selon la revendication 7, **caractérisée en ce que** les enceintes (2) des deux postes (1) adjacents d'un groupe de postes sont rapprochées l'une contre l'autre et juxtaposées.

9. Installation selon l'une quelconque des revendications 1 à 8, caractérisée, pour chaque poste (1),
en ce que le bloc supérieur formant couvercle (3) est fixe et solidaire de l'enceinte (2) respective, et
en ce que le fond (10) de l'enceinte (2) est déplaçable axialement pour autoriser l'introduction et l'évacuation des récipients (5), disposés col en haut, par le bas de l'enceinte.

10. Installation selon l'une quelconque des revendications 1 à 9, **caractérisée en ce qu'**elle est du type carrousel tournant et comporte un bâti rotatif supportant ladite multiplicité de postes (1) répartis périmétriquement.

## Claims

1. Installation for depositing, by means of a microwave plasma, a barrier coating on the internal surface of containers (5) made of a thermoplastic such as PET, this installation comprising a multiplicity of container treatment stations (1) each comprising a treatment enclosure (2) and an upper block forming a cover (3) and including a vacuum pumping chamber in which connection means (4) for sealed connection to the container (5) comprise a sleeve (6) of tubular general shape co-axial with the neck (7) of the container (5), each cover (3) also supporting an injector (8) co-axial with said sleeve (6) and suitable for injecting a reactive fluid into the container (5) during the treatment, **characterized in that** members are chosen from among the sleeves (6) and the injectors (8), of several adjacent stations (1) forming a group of stations,
- **in that** the sleeves (6) of said adjacent stations (1) of the group of stations are fastened to a single sleeve-carrying plate (15) that extends as a bridge over the covers (3) of said stations;
- **in that** the injectors (8) of said adjacent stations (1) of the group of stations are fastened to a single injector-carrying plate (20) that extends as a bridge over the covers (3) of said stations; and
- **in that** the injector-carrying plate (20) is located on top of the sleeve-carrying plate (15);
whereby said plate (15, 20) and the members (6, 8) of said stations (1) of the group of stations that said plate supports constitute a unitary assembly (16, 21) that can be manoeuvred as one piece in order to fit said members (6, 8) onto the respective covers (3) or to remove them therefrom.

2. Installation according to Claim 1, **characterized in that** each plate (15, 20) includes, in its central part, a gripping means (17, 22) suitable for manoeuvring the unitary assembly (16, 21).

3. Installation according to Claims 1 and 2, **characterized in that**, in their respective central parts, the sleeve-carrying plate (15) and the injector-carrying plate (20) are mutually offset in transversely opposed directions, **in that** the respective gripping means (17, 22) are located side by side and **in that** the means (17) for gripping the sleeve-carrying plate (15), located beneath, allows the assembly comprising the two, sleeve-carrying (15) and injector-carrying (20), plates to be handled as one piece.

4. Installation according to any one of Claims 1 to 3, **characterized in that** each unitary assembly (16, 21) is designed for automatically establishing fluidic and/or electrical connections (26) with the associated covers (3).

5. Installation according to any one of Claims 1 to 4, **characterized in that** each plate (15, 20) is provided with at least one guiding finger (18, 23) which is substantially parallel to the axes of the members (6, 8) supported by said plate and which is received in the element subjacent to said plate.

6. Installation according to Claims 1 and 5, **characterized in that** the sleeve-carrying plate (15) located beneath is provided with at least one through-housing (25) suitable for the at least one guiding finger (23) of the injector-carrying plate (20) located above to pass through it.

7. Installation according to Claim 6, **characterized in that** it comprises an even number of stations (1), **in that** each group of stations comprises two adjacent stations (1) and **in that** each plate (15, 20) supports several members (6, 8) belonging to the two respective adjacent stations (1) of a group of stations.

8. Installation according to Claim 7, **characterized in that** the enclosures (2) of the two adjacent stations (1) of a group of stations are brought together and juxtaposed.

9. Installation according to any one of Claims 1 to 8, **characterized in that**, for each station (1), the upper block forming the cover (3) is stationary and fastened to the respective enclosure (2) and **in that** the bottom (10) of the enclosure (2) can move axially in order to permit the insertion and extraction of the containers (5), placed neck up, via the base of the enclosure.

10. Installation according to any one of Claims 1 to 9, **characterized in that** it is of the rotating carousel type and includes a rotary frame that supports said multiplicity of stations (1) distributed on the perimeter thereof.

## Patentansprüche

1. Vorrichtung zur Beschichtung mittels Mikrowellenplasma für eine Beschichtung, die eine Abdeckung auf der Innenfläche von Behältern (5) aus thermoplastischem Material, wie zum Beispiel PET, ausbildet, wobei die Vorrichtung eine Vielzahl von Behandlungsstationen (1) für Behälter aufweist, die jeweils einen Behandlungsraum (2) aufweisen und einen oberen Block, der eine Abdeckung (3) einschließlich einer Vakuumpumpkammer ausbildet, in der ein dichtendes Verbindungsmittel (4) zu dem Behälter (5) einen Mantel (6) mit einer im Allgemeinen röhrenförmigen zum Hals (7) des Behälters (5) koaxialen Form aufweist, wobei jede Abdeckung (3) auf gleiche Weise einen zu dem Mantel (6) koaxialen Injektor (8) unterstützt, der zum Einspritzen eines bei der Behandlung in dem Behälter (5) reaktives Fluid geeignet ist,
**dadurch gekennzeichnet, dass** die Einrichtungen unter den Mänteln (6) und den Injektoren (8) ausgewählt werden und die Vielzahl aneinandergrenzenden Stationen (1) eine Stationsgruppe ausbilden,
- dass die Mäntel (6) von den aneinandergrenzenden Stationen (1) der Stationsgruppe über eine einzelne Manteltrageplatte (15) verbunden sind, die sich brückenförmig über die Abdeckungen (3) der Stationen erstreckt,
- dass die Injektoren (8) der aneinandergrenzenden Stationen (1) von der Stationsgruppe über eine einzelne Injektortrageplatte (20) verbunden sind, die sich brückenförmig oberhalb der Abdeckungen (3) von den Stationen erstreckt, und
- dass die Injektortrageplatte (20) oberhalb zu der Manteltrageplatte (15) angeordnet ist,
wodurch die Platte (15, 20) und die Einrichtungen (6, 8) von den Stationen (1) der Stationsgruppe, die sie unterstützt, einen einheitlichen als Block beweglichen Aufbau (16, 21) ausbilden, um die Einrichtungen (6, 8) auf den jeweiligen Abdeckungen (3) zu platzieren oder sie anzuheben.

2. Vorrichtung nach Anspruch 1, **dadurch gekennzeichnet, dass** jede Platte (15, 20) in ihrem mittleren Abschnitt ein Greifmittel (17, 22) aufweist, das zum Bewegen des einheitlichen Aufbaus (16, 21) geeignet ist.

3. Vorrichtung nach Anspruch 1 und 2, **dadurch gekennzeichnet, dass** die Manteltrageplatte (15) und die Injektortrageplatte (20) in ihren jeweiligen mittleren Abschnitten zueinander quer gegenüberliegend versetzt sind, dass die jeweiligen Greifmittel (17, 22) nebeneinander angeordnet sind und dass das Greifmittel (17) der Manteltrageplatte (15), die unten angeordnet ist, es ermöglicht, die zwei Platten, die Manteltrageplatte (15) und Injektortrageplatte (20), zusammen als Block zu transportieren.

4. Vorrichtung nach einem der Ansprüche 1 bis 3, **dadurch gekennzeichnet, dass** jeder einheitliche Aufbau (16, 21) eingerichtet ist, um automatisch mit den zugehörigen Abdeckungen (3) fluide (26) und/oder elektrische Verbindungen herzustellen.

5. Vorrichtung nach einem der Ansprüche 1 bis 4, **dadurch gekennzeichnet, dass** jede Platte (15, 20) mit mindestens einem Führungszapfen (18, 23) versehen ist, der im Wesentlichen parallel zu den Achsen der Einrichtungen (6, 8) ist, die durch die Platte unterstützt werden, und der in dem unterhalb der Platte angrenzenden Element aufgenommen ist.

6. Vorrichtung nach einem der Ansprüche 1 und 5, **dadurch gekennzeichnet, dass** die unterhalb angeordnete Manteltrageplatte (15) mit mindestens einer Eingangsaufnahme (25) versehen ist, die geeignet ist, das sie der mindestens eine Führungszapfen (23) der oberhalb angeordneten Injektortrageplatte (20) passiert.

7. Vorrichtung nach Anspruch 6, **dadurch gekennzeichnet, dass** sie eine Anzahl von Stationspaaren (1) aufweist, dass jede Stationsgruppe zwei aneinandergrenzende Stationen (1) aufweist und dass jede Platte (15, 20) mehrere Einrichtungen (6, 8) unterstützt, die jeweils zu den zwei angrenzenden Stationen (1) einer Stationsgruppe gehören.

8. Vorrichtung nach Anspruch 7, **dadurch gekennzeichnet, dass** die Räume (2) der zwei aneinandergrenzenden Stationen (1) einer Stationsgruppe dicht aneinander liegen und aneinandergereiht sind.

9. Vorrichtung nach einem der Ansprüche 1 bis 8, **dadurch gekennzeichnet, dass** für jede Station (1),
der oberhalb liegende Block, der die Abdeckung (3) ausbildet, an dem jeweiligen Raum (2) befestigt und einstückig ist, und
der Boden (10) des Raums (2) axial versetzbar ist, um das Einführen und Ausführen der Behälter (5) zuzulassen, die mit dem Hals nach oben im Unteren des Raums angeordnet sind.

10. Vorrichtung nach einem der Ansprüche 1 bis 9, **dadurch gekennzeichnet, dass** sie karusselförmig ist, sich dreht und ein rotierbares tragendes Element aufweist, dass die Vielzahl der über den Umfang verteilten Stationen (1) unterstützt.
